(19) Europäisches Patentamt
European Patent Office
Office européen des brevets

(11) **EP 4 109 117 B1**

(12) **EUROPEAN PATENT SPECIFICATION**

(45) Date of publication and mention
of the grant of the patent:
**14.02.2024 Bulletin 2024/07**

(21) Application number: **21181223.5**

(22) Date of filing: **23.06.2021**

(51) International Patent Classification (IPC):
**G01R 31/367** (2019.01)        **G01R 31/389** (2019.01)

(52) Cooperative Patent Classification (CPC):
**G01R 31/389; G01R 31/367;** Y02E 60/10

(54) **BATTERY IMPEDANCE ESTIMATION METHOD**

BATTERIEIMPEDANZSCHÄTZUNGSVERFAHREN

PROCÉDÉ D'ESTIMATION D'IMPÉDANCE DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.12.2022 Bulletin 2022/52**

(73) Proprietor: **TWAICE Technologies GmbH
80807 München (DE)**

(72) Inventors:
• **KONDAVALASA, Saiveer Patnaik
80634 Munich (DE)**
• **ATUKALP, Devin
81735 München (DE)**

(74) Representative: **Kraus & Lederer PartGmbB
Thomas-Wimmer-Ring 15
80539 München (DE)**

(56) References cited:
• REMMLINGER JURGEN ET AL: "Identification of a bilinear and parameter-varying model for lithium-ion batteries by subspace methods", 2015 AMERICAN CONTROL CONFERENCE (ACC), IEEE, 17 June 2013 (2013-06-17), pages 2268-2273, XP032476653, ISSN: 0743-1619, DOI: 10.1109/ACC.2013.6580171 [retrieved on 2013-08-14]

• HU Y ET AL: "Linear parameter varying battery model identification using subspace methods", JOURNAL OF POWER SOURCES, ELSEVIER, AMSTERDAM, NL, vol. 196, no. 5, 1 March 2011 (2011-03-01) , pages 2913-2923, XP027566960, ISSN: 0378-7753 [retrieved on 2010-12-20]

• FLEISCHER CHRISTIAN ET AL: "On-line adaptive battery impedance parameter and state estimation considering physical principles in reduced order equivalent circuit battery models part 2. Parameter and state estimation", JOURNAL OF POWER SOURCES, ELSEVIER, AMSTERDAM, NL, vol. 262, 27 March 2014 (2014-03-27), pages 457-482, XP029025943, ISSN: 0378-7753, DOI: 10.1016/J.JPOWSOUR.2014.03.046

• DONG GUANGZHONG ET AL: "Sequential Monte Carlo Filter for State-of-Charge Estimation of Lithium-Ion Batteries Based on Auto Regressive Exogenous Model", IEEE TRANSACTIONS ON INDUSTRIAL ELECTRONICS, IEEE SERVICE CENTER, PISCATAWAY, NJ, USA, vol. 66, no. 11, 1 November 2019 (2019-11-01), pages 8533-8544, XP011733258, ISSN: 0278-0046, DOI: 10.1109/TIE.2018.2890499 [retrieved on 2019-07-01]

• GOULD C R ET AL: "New Battery Model and State-of-Health Determination Through Subspace Parameter Estimation and State-Observer Techniques", IEEE TRANSACTIONS ON VEHICULAR TECHNOLOGY, IEEE, USA, vol. 58, no. 8, 1 October 2009 (2009-10-01), pages 3905-3916, XP011277463, ISSN: 0018-9545, DOI: 10.1109/TVT.2009.2028348

**Description**

The present invention relates to a method and an apparatus for estimating an impedance of a battery.

**Background**

Batteries are finding more and more applications in everyday use. To ensure that batteries are properly used, which is crucial in extracting the maximum performances and prolonging their life, battery analysis and management is becoming more and more crucial.

A variety of battery parameters are used for battery analysis and management. Among them, the impedance of a battery has a relevant role due the following reasons.

The impedance is used to determine the power capability of a battery. Moreover, batteries, particularly lithium-ion batteries, can be sensitive to overvoltage/undervoltage. The impedance value can be used to determine the maximum allowed current thus avoiding exceeding voltage limits. Additionally, batteries, particularly lithium-ion batteries, generally age over time. The impedance value is also a key indicator of the ageing of the battery. Furthermore, heat generation of batteries can be quantified using the impedance. Thermal management control can thus use knowledge of the impedance for more effective/efficient operation. Still further, in various advanced battery control systems, the impedance value is used in various model based estimations such as state-of-charge and state-of-energy, and predictions, such as EV range.

The impedance value of a battery is thus of high relevance for an improved use and/or management of the battery. As this value changes over time, its measurement over time is usually also desired.

Various manners are known in the art for measuring and/or estimating a battery impedance.

The impedance can be determined before beginning of life. The simplest way is to have a static look-up table for impedance. The look-up table can be created using a characterization test at beginning of life of the battery. The impedance of similar batteries can then be estimated by means of the look-up table. As an extension, change of impedance over battery lifetime can be modelled using data collected in laboratory tests. In particular, tests can be carried out on a sample battery from begin of life to end of life in laboratory. The look-up table can then be extended to also take into account ageing.

This approach has high cost due to extensive testing. Moreover, modelling the impedance throughout the lifetime of the battery is complex.

An alternative manner for estimating the impedance can be based on measurements taken on the battery during operation. For instance, during the lifetime of the battery, operation of the battery can be periodically interrupted for diagnostics. During those interruption, a given current and/or voltage pulse is inputted to the battery and the respective voltage and/or current response is measured. In this manner, the DC resistance can be calculated. Similarly, an AC current and/or voltage can be inputted to the battery and its voltage and/or current response can be measured, so as to obtain the AC impedance. The AC frequency can be constant, such as with 1kHz resistance measurement devices often employed by the automotive industry, or varying, such as with electrochemical impedance spectroscopy.

This approach has the disadvantage that operation of the battery needs periodic interruption, which is usually not acceptable for the users. Moreover, it requires measurement equipment to be present at all time in connection with the battery, which increases costs. Furthermore the analysis of the data from such measurement equipment is often inaccurate due to ill-posed optimization and noisy data from sensors and requires a high computational effort.

There is thus a need for a method for estimating battery impedance which can be implemented in a simple and/or cost-effective manner and provide reliable results.

Battery modelling according to the state of the art is known from, for instance, REMMLINGER JURGEN ET AL: "Identification of a bilinear and parameter-varying model for lithium-ion batteries by subspace methods", 2015 AMERICAN CONTROL CONFERENCE (ACC), IEEE, 17 June 2013, HU Y ET AL: "Linear parameter varying battery model identification using subspace methods", JOURNAL OF POWER SOURCES, ELSEVIER, AMSTERDAM, NL, vol. 196, no. 5, 1 March 2011, FLEISCHER CHRISTIAN ET AL: "On-line adaptive battery impedance parameter and state estimation considering physical principles in reduced order equivalent circuit battery models part 2. Parameter and state estimation", JOURNAL OF POWER SOURCES, ELSEVIER, AMSTERDAM, NL, vol. 262, 27 March 2014, DONG GUANGZHONG ET AL: "Sequential Monte Carlo Filter for State-of-Charge Estimation of Lithium-Ion Batteries Based on Auto Regressive Exogenous Model", IEEE TRANSACTIONS ON INDUSTRIAL ELECTRONICS, IEEE SERVICE CENTER, PISCATAWAY, NJ, USA, vol. 66, no. 11, 1 November 2019, and GOULD C R ET AL: "New Battery Model and State-of-Health Determination Through Subspace Parameter Estimation and State-Observer Techniques", IEEE TRANSACTIONS ON VEHICULAR TECHNOLOGY, IEEE, USA, vol. 58, no. 8, 1 October 2009.

## Summary of the invention

The present invention is generally based on the concept that the impedance of a battery can be measured from voltage and/or current measurement taken while the battery is being used. In particular, embodiments of the invention generally relate to how data from those measurements can be selected and manipulated so as to obtain an estimation of the impedance.

The invention thus allows the impedance to be estimated without requiring extensive characterization of the battery and without interrupting operation of the battery. Moreover, as only voltage and/or current data are needed from the battery, the invention can be implemented in most systems comprising a battery, as most systems are provided with sensors measuring those values. Advantageously, the impedance can thus be estimated remotely, without having physical access to the battery.

The invention is defined by the independent claims.

An aspect of the invention can in particular relate to a method for estimating an impedance of a battery, the method can comprise the steps of: acquiring data of the battery during at least a predetermined time range, the data comprising at least a plurality of voltage measurements and a plurality of current measurements, determining a time window within the predetermined time range, the time window starting after a relaxed voltage interval and comprising a dynamic load interval, determining an initial voltage, the initial voltage being the voltage measurement at the start of the time window, determining a plurality of dynamic voltages based on the voltage measurements in the time window and the initial voltage, executing a subspace identification analysis based on the plurality of current measurements and on the plurality of dynamic voltages, computing the impedance from an output of the subspace identification analysis.

Thanks to this approach it is advantageously possible to decouple the dynamic component of the voltage measurements from the static component thereof. Thanks to this separation, the dynamic component can be inputted to a subspace identification analysis which can enable the computation of the battery impedance.

In some cases, the time window can start immediately after an end of the relaxed voltage interval.

Thanks to this approach it is advantageously possible to ensure that the open state of charge computed at the end of the relaxed voltage interval can correspond to the state of charge at the beginning of the time window.

In some cases the time window can start within a predetermined time after an end of the relaxed voltage interval RVI.

Thanks to this approach it is advantageously possible to ensure that the open state of charge computed at the end of the relaxed voltage interval can substantially correspond to the state of charge at the beginning of the time window.

In some cases, the dynamic load interval can be a time interval during which the following condition apply: a value of an integral of an absolute value of the current measurements is within a predetermined range, preferably higher than 1% of the capacity of the battery, and/or preferably lower than 5% of the capacity of the battery, and/or even more preferably lower than 2.5% of the capacity of the battery.

In some cases, the dynamic load interval can be a time interval during which the following condition apply: a difference of a maximum value of an integral of the current measurements during the time interval and a minimum value of the integral of the current measurements during the time interval is within a predetermined range, preferably higher than 2.5% and/or preferably lower than 5% of the battery cell capacity.

Thanks to those approaches it is advantageously possible to contain the amount of charge/discharge of the battery during the dynamic load interval to a value which results in a reliable estimation of the battery impedance, while also ensuring a sufficient dynamic behaviour of the battery, which is helpful in correctly estimating the impedance.

In some cases, the dynamic load interval can be a time interval during which the following condition apply: a value of statistical measure for dispersion of the current measurements, preferably the standard deviation of the current measurements, is higher than a predetermined value, preferably higher than 10% of the C-rate of the battery, even more preferably higher than 25% of the C-rate of the battery.

In some cases, the dynamic load interval can be a time interval during which the following condition apply: an absolute value of a differential of the current measurements reaches a predetermined threshold, preferably higher than 1 C-rate/s. In some cases, the dynamic load interval can be a time interval during which the following condition apply: an absolute value of a differential of a moving average of the current measurements reaches a predetermined threshold, preferably higher than 1 C-rate/s.

In some cases, the dynamic load interval can be a time interval during which the following condition apply: a Fourier transformation of the current measurements results in one or more frequency peaks other than at 0 Hz.

Thanks to those approaches it is advantageously possible to ensure that a sufficient dynamic behaviour of the battery is part of the dynamic load interval.

In some cases the dynamic load interval can have a duration of and/or at least 1 minute, preferably of and/or at least 5 minutes.

In some cases, the battery can be modelled as having one or more RC elements, and the dynamic load interval can have a duration of and/or at least 1 time, preferably of and/or at least 5 times, the biggest of the one or more RC elements.

Thanks to those approaches it is advantageously possible to ensure a length of the dynamic load interval which contains sufficient data for a reliable observation of the battery dynamics and thus for a reliable computation of the impedance.

According to the invention the step of determining the dynamic voltage comprises the steps of: determining an estimated initial state of charge based on the initial voltage, the estimated initial state of charge being the estimated state of charge at the start of the time window, determining a plurality of estimated states of charge throughout the time window based on the estimated initial state of charge, determining a plurality of estimated open circuit voltages throughout the time window based on the estimated plurality of states of charge, determining the plurality of dynamic voltages as, at any given time throughout the time window, a difference between the voltage measurement and the respective estimated open circuit voltage at the given time.

Thanks to this approach it is advantageously possible to track the static component of the voltage measurements throughout the time window so as to remove the static component from the voltage measurements, leaving the dynamic component for subsequent analysis.

In some cases, the subspace identification analysis can be performed with the plurality of current measurements as input and the plurality of dynamic voltages as output.

Thanks to this approach it is advantageously possible to create a state-space representation of the battery, from which the subspace identification analysis allows extraction of the impedance.

In some cases, the subspace identification analysis can be based on a state-space representation of the type of

$$x_{k+1} = A\, x_k + B\, u_k$$

$$y_{k+1} = C\, x_k + D\, u_k$$

wherein

- k represents a time instant of the time window,
- k+1 represents a time instant subsequent to k,
- $x_k$ represents a state vector at time k,
- $u_k$ represents a current measurement at time k,
- $y_k$ represents a value of the plurality of dynamic voltages at time k,
- A represents a state transition matrix,
- B represents a control input matrix,
- C represents an output matrix,
- D represents a feedthrough matrix.

Thanks to this approach it is advantageously possible to easily and reliably create state-space representation of the battery.

In some cases the step of executing a subspace identification analysis can comprise any of the steps of orthogonal projection of block Hankel matrix of the current measurements, orthogonal projection of block Hankel matrix of the dynamic voltages, oblique projection of the orthogonal projection of the block Hankel matrix of the current measurements, oblique projection of the orthogonal projection of the block Hankel matrix of the dynamic voltages.

Thanks to this approach it is advantageously possible to project out noise from the states, through the orthogonal projection, and obtain a filtered observability matrix, through the oblique projection.

In some cases the step of executing a subspace identification analysis can further comprise the step of singular vector decomposition to obtain the system matrix A.

Thanks to this approach it is advantageously possible to extract the resistances and time constants from the system matrix A which allows computation of the impedance. A further aspect of the invention can relate to an apparatus for estimating an impedance of a battery, the apparatus comprising a memory and a processor, wherein the memory comprises instructions configured to, when executed, cause the processor to carry out any of the steps described.

Thanks to this approach it is advantageously possible to implement the invention in form of hardware.

In some cases, the apparatus can further comprise communication means for obtaining the plurality of voltage measurements and the plurality of current measurements.

Thanks to this approach it is advantageously possible to remotely determine the impedance of the battery based on simple current and voltage measurements.

A further aspect of the invention can relate to a software which, when executed on a processor, causes the processor to carry out any of the steps described.

Thanks to this approach it is advantageously possible to provide the invention in form of software which can be executed independently on the location of the battery.

**Brief description of the drawings**

In the followings, aspects of the invention will be described with reference to the drawings, in which like reference numerals indicate like elements, and in which:

figure 1 schematically illustrates a method 1000 for estimating an impedance of a battery;

figure 2 schematically illustrates an apparatus 2000 for estimating an impedance of a battery;

figure 3A schematically illustrates an exemplary voltage measurement over time;

figure 3B schematically illustrates an exemplary current measurement over time;

figure 4 schematically illustrates a possible implementation of a dynamic voltage determination step S4400;

figure 5 schematically illustrates a possible implementation of a subspace identification analysis execution step S5500,

figure 6A schematically illustrates an exemplary state of charge over time;

figure 6B schematically illustrates an exemplary open circuit voltage over time;

figure 7A schematically illustrates an exemplary voltage measurement over time;

figure 7B schematically illustrates an exemplary dynamic voltage over time.

**Detailed description of preferred embodiments**

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

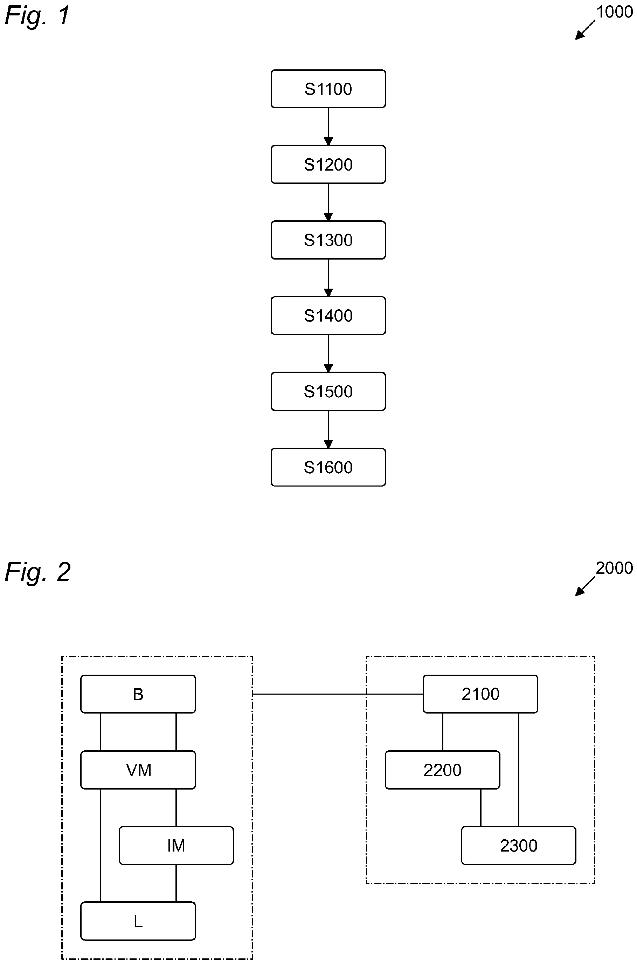

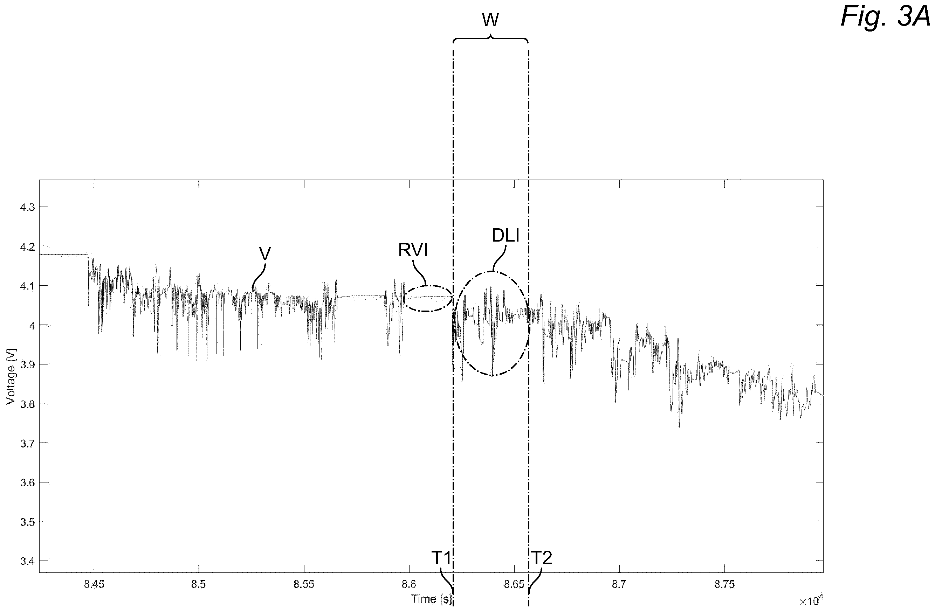

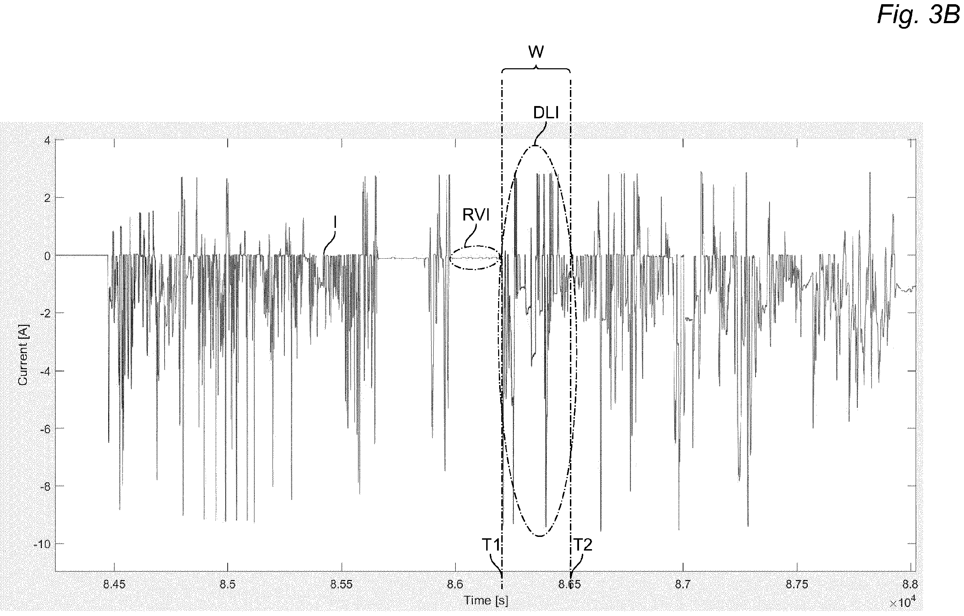

Figure 1 schematically illustrates a method 1000 for estimating an impedance of a battery B. The method comprises a step S1100 of acquiring data of the battery B during at least a predetermined time range, the data comprising at least a plurality of voltage measurements and a plurality of current measurements. Example voltage measurements are visible in figure 3A while example current measurements are visible in figure 3B. In some embodiments, the measurements are preferably sampled with at least the Nyquist frequency of the respective signals.

The method 1000 further comprises a step S1200 of determining a time window W within the predetermined time range, the time window W starting after a relaxed voltage interval RVI of the battery and comprising a dynamic load interval DLI of the battery. In some preferred embodiments, the time window W starts immediately after an end of the relaxed voltage interval RVI. In other words, the end time of the relaxed voltage interval RVI can correspond to the start time of the time window W. In some preferred embodiments, the time window W starts within a predetermined time after an end of the relaxed voltage interval RVI. The predetermined time can preferably be less than 1 minute. Alternatively, or in addition, the predetermined time can be determined so that the state of charge of the battery does not significantly change during the predetermined time.

In general, it will be clear that in general the dynamic load interval DLI can start at any point after a relaxed voltage interval RVI. The relaxed voltage interval RVI can be used to reliably measure the open circuit voltage and thus reliably derive a state of charge of the battery. The state of charge of can then be tracked for any amount of time, in particular at least until the beginning of relaxed voltage interval RVI, so as to provide an initial state of charge, and thus an initial open circuit voltage, of the relaxed voltage interval RVI. The choice of a relaxed voltage interval RVI close, or immediately after, a relaxed voltage interval RVI provides at least the advantage that the tracking of the state of charge can be reduced or avoided entirely.

The relaxed voltage interval RVI is generally a time interval in which the battery is not under significant charge and/or discharge, as known to the skilled person, preferably under no charge and/or discharge, even more preferably for a time sufficient for the open circuit voltage to stabilize. In some embodiments, the relaxed voltage interval RVI can thus be determined to be a time interval during which the voltage is stable within a predetermined range, for at least a predetermined time duration. Alternatively, or in addition, in some embodiments, the relaxed voltage interval RVI can be determined to be a time interval during which the absolute value of the current is lower than a predetermined threshold, for at least a predetermined time duration. In preferred embodiments, the time interval can be at least 1 minute, preferably at least 5 minutes and/or the

The dynamic load interval DLI is generally a time interval comprising charging and/or discharging of the battery, preferably both charging and discharging. In some embodiments, the dynamic load interval DLI can thus be determined to be a time interval during which the voltage is varying outside of a predetermined range, for at least a predetermined time duration. Alternatively, or in addition, in some embodiments, the dynamic load interval DLI can be determined to be a time interval during which the absolute value of the current is higher than a predetermined threshold, for at least a predetermined time duration. It will be appreciated that the numerical values for those ranges, thresholds and time durations are dependent on the characteristics of the battery, such as technology, capacity, voltage and maximum rated output current, and it will be clear to the skilled person how to identify a relaxed voltage interval RLG and a dynamic load interval DLI for a given specific battery.

In some embodiments, the dynamic load interval DLI can be defined as a time interval during which one or more of the following conditions apply.

One condition for identifying the dynamic load interval DLI can be if a value of an integral of an absolute value of the current measurements I is within a predetermined range. That is, an absolute value of the current measurements I can be integrated over the time interval and, if the result is within a predetermined range, the time interval can be considered to be a dynamic load interval DLI. In some embodiments, the predetermined range can be higher than 1% of the capacity of the battery B, and/or preferably lower than 5% of the capacity of the battery B, and/or even more preferably lower than 2.5% of the capacity of the battery B.

Thanks to the upper limitation on the integral of the absolute value of the current measurements I, it can be advantageously ensured that the variation of open circuit voltage, throughout the dynamic load interval DLI, is contained.

One further condition for identifying the dynamic load interval DLI can be if a difference of a maximum value of an integral of the current measurements I during the time interval and a minimum value of the integral of the current measurements I during the time interval is within a predetermined range. That is, the current measurements I can be integrated throughout the time interval, and the integral will assume different values throughout the time interval, among which a minimum and a maximum one. In some embodiments, the predetermined range is preferably higher than 2.5% and/or preferably lower than 5% of the battery cell capacity.

One further condition for identifying the dynamic load interval DLI can be if a value of statistical measure for dispersion of the current measurements I, preferably the standard deviation of the current measurements I, is higher than a predetermined value. In some embodiments, the predetermined value can be preferably higher than 10% of the C-rate of the battery, even more preferably higher than 25% of the C-rate of the battery.

One further condition for identifying the dynamic load interval DLI can be if an absolute value of a differential of the current measurements I reaches a predetermined threshold. In some embodiments, the predetermined threshold can preferably be higher than 1 C-rate/s.

One further condition for identifying the dynamic load interval DLI can be if an absolute value of a differential of a moving average of the current measurements I reaches a predetermined threshold. In some embodiments, the predetermined threshold can preferably be higher than 1 C-rate/s.

One further condition for identifying the dynamic load interval DLI can be if a Fourier transformation of the current measurements I results in one or more frequency peaks other than at 0 Hz.

Alternatively, or in addition, in some embodiments the dynamic load interval DLI can be defined as a time interval having a duration which can be of and/or at least 1 minute, preferably of and/or at least 5 minutes. That is, in some embodiments this can be considered to be a complete duration for the dynamic load interval DLI, while in some other embodiments, this can be considered to be minimum duration for the dynamic load interval DLI.

Still alternatively, or in addition, in some embodiments the dynamic load interval DLI can be defined as a time interval having a minimum duration which depends on the RC values associated to the impedance of the battery. In particular, the battery B can be modelled as having one or more RC elements, as will be described more in details in the following, and the dynamic load interval DLI can have a duration of and/or at least 1, preferably of and/or at least 5, times the biggest of the one or more RC elements. That is, in some embodiments this can be considered to be a complete duration for the dynamic load interval DLI, while in some other embodiments, this can be considered to be minimum duration for the dynamic load interval DLI.As exemplary time window W from time T1 to time T2 is illustrated, for instance, in both figures 3A and 3B.

As it can be seen in figure 3A, the relaxed voltage interval RVI is visible by the voltage signal V remaining substantially stable for a time interval prior to T1, roughly from 8.6 x 10^4 seconds to 8.62 x 10^4 seconds which, for the battery under consideration, is sufficient to determine a relaxed voltage condition. Alternatively, or in addition, as visible in figure 3B, the relaxed voltage interval RVI can be identified by the current signal I remaining substantially at 0 for a time interval prior to T1, roughly from 8.6 x 10^4 seconds to 8.62 x 10^4 seconds which, for the battery under consideration, is sufficient to determine a relaxed voltage condition.

Similarly, as it can be seen in figure 3A, the dynamic load interval DLI is visible by the voltage signal V varying outside of a predetermined range after T1, roughly from 8.62 x 10^4 seconds onward. Alternatively, or in addition, as visible in figure 3B, the dynamic load interval DLI can be identified by the current signal I complying with one or more of the criteria previously indicated.

As will become clear from the following description, the identification of a time window W starting after a relaxed voltage interval RVI of the battery B and comprising an appropriate dynamic load interval DLI of the battery B allows the dynamic component of the signals from the dynamic load interval DLI, in particular of the voltage V, to be separated from their static component.

In particular, the battery voltage V contains both a dynamic component, also known as over potential, or dynamic voltage, and a static component, also known as open circuit voltage, or static voltage. For reasons which will become clearer in the following, it is advantageous to remove the static component so as to allow the method 1000 to estimate the dynamic component. By choosing a time window W starting after a relaxed voltage interval RVI, it is possible to estimate and/or measure the static component, that is, the open circuit voltage, at the beginning of the window W and easily remove the static component from the voltage measurements V, as will be described more in details in the following description.

Moreover, for the execution of method 1000 it is advantageous to have an initial estimate of the dynamic component, that is, of the over potentials. By choosing a window W starting at the end of a relaxed voltage interval RVI, those estimates can be approximated to zero, which allows a simplified estimate procedure.

It is thus clear that the selection of the time window W based on the one or more described criteria allows data to be extracted in a particularly advantageous manner, which then allows those data to be used in a subspace identification analysis for determining the battery impedance.

The method 1000 further comprises a step S1300 determining an initial voltage, the initial voltage being the voltage measurement V at the start of the time window W. In some embodiments, particularly when the time window W is close to the end of the relaxed voltage interval RVI, the initial voltage can also correspond to the voltage measurement V at the end of the relaxed voltage interval RVI, or to an average of the voltage measurements V during the relaxed voltage interval RVI, or more generally to an open circuit voltage based on the voltage measurement V during the relaxed voltage interval RVI

The method 1000 further comprises a step S1400 of determining a plurality of dynamic voltages based on the voltage measurements V in the time window W and the initial voltage. Generally, as will become clearer from the following, knowledge of the initial voltage allows the determination of the dynamic component of the voltage throughout the time window W

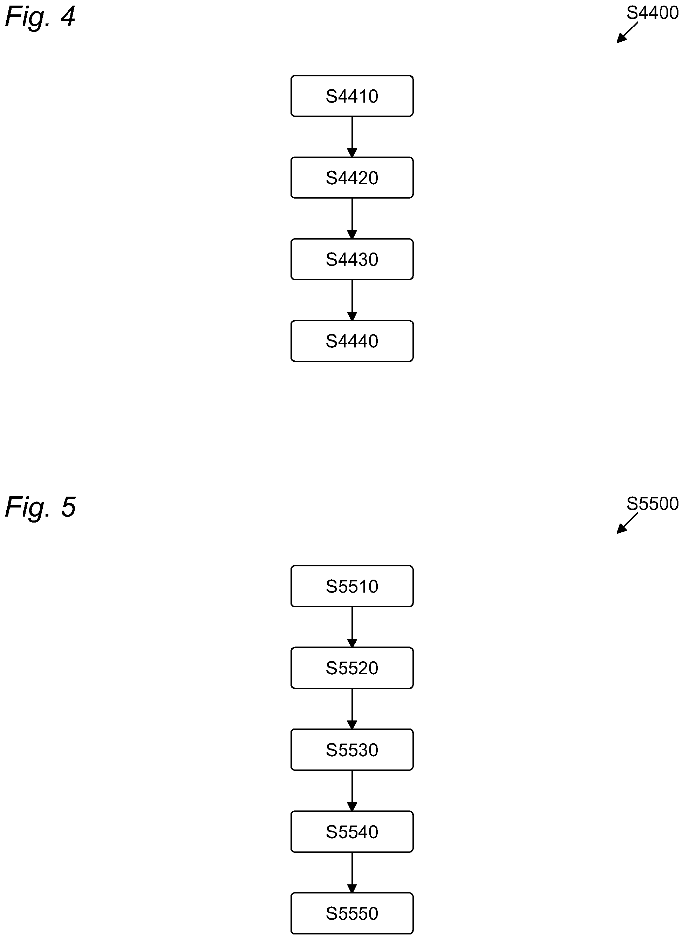

In particular, according to the invention as illustrated in figure 4, the step S4400 implements the step S1400 of determining the dynamic voltage and comprises a step S4410 of determining an estimated initial state of charge based on the initial voltage, the estimated initial state of charge being the estimated state of charge at the start of the time window W. It will be clear to those skilled in the art that a plurality of manners are known for determining an estimated state of charge based on a voltage value. For instance, a look-up table could be used, linking the open circuit voltage and the estimated state of charge.

An exemplary execution of the method on the exemplary current measurements I and voltage measurements V of figures 3A and 3B can, for instance, result in an initial voltage of approximately 4,072V which, for the exemplary battery under consideration, corresponds to an estimated initial state of charge of approximately 86,4%.

The step S4400 further comprises a step S4420 of determining a plurality of estimated states of charge throughout the time window W based on the estimated initial state of charge. Also in this case, it will be clear to those skilled in the art that a plurality of approaches are known for estimating the evolution of the state of charge of a battery based on a known initial state of charge. For instance, the estimated of charge at any given time throughout the time window can be obtained by adding the integral value of the current measurement I to the initial state of charge.

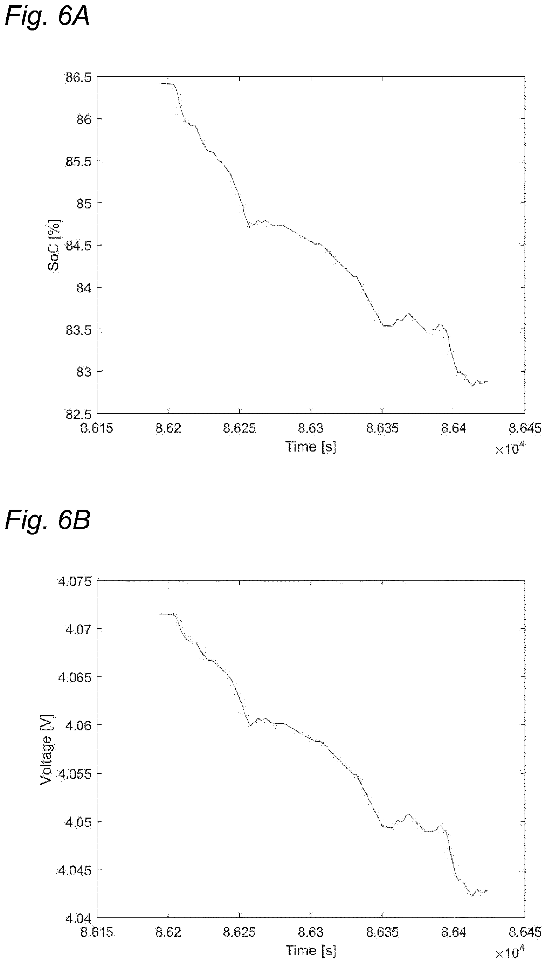

Referring back to the exemplary execution indicated above, figure 6A shows an exemplary evolution of the estimated states of charge throughout the time window W. In this example, the estimated states of charge substantially decrease throughout the time window W.

The step S4400 further comprises a step S4430 of determining a plurality of estimated open circuit voltages throughout the time window W based on the estimated plurality of states of charge. As previously discussed, various manners such as a look-up table could be implemented for the conversion.

Referring back to the exemplary execution indicated above, figure 6B shows an exemplary evolution of the estimated open circuit voltages throughout the time window W

The step S4400 then further comprises a step S4440 of determining the plurality of dynamic voltages as, at any given time throughout the time window W, a difference between the voltage measurement V and the respective estimated open circuit voltage at the given time. In this manner, at any given time, the static component of the voltage measurement V is removed from the voltage measurement V thus leaving only the dynamic component.

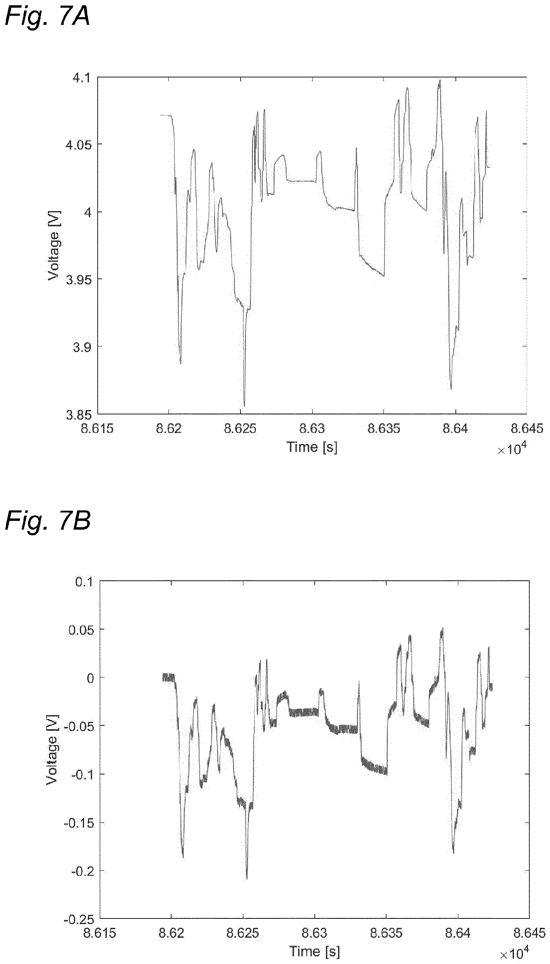

Referring back to the exemplary execution indicated above, figure 7A shows an enlarged portion of the voltage measurements of the time window W, approximately from $8,615 \times 10^4$ seconds to $8,645 \times 10^4$ seconds.

Similarly, figure 7B shows the dynamic voltage during the time window, obtained by the difference between the voltage measurements V and the static component, that is, the estimated open circuit voltages.

With this approach it is thus possible to extract the dynamic component from the respective voltage measurements V at any point in time of the time window W with a simple and reliable manner. It will however be clear that alternative manners could be implemented for extracting the dynamic component from the respective voltage measurements V and the invention is not to be limited to the specific implementation illustrated in figure 4. In general, the purpose of step S1400 is to obtain a plurality of dynamic voltages, that is, the dynamic component of the voltage measurements V, throughout the time window W based on the knowledge of the initial voltage.

Alternatively, in some embodiments, the open circuit voltage throughout the dynamic load interval DLI can be alternatively considered to be substantially constant, particularly if the dynamic load interval DLI is selected so that the integral of the absolute value of the current measurements during the dynamic load interval DLI is lower than a predetermined threshold. This approach has the advantage that it is not necessary to determine a plurality of open circuit voltages throughout the dynamic load interval DLI but a single value can be used, thus simplifying the method.

The method 1000 further comprises a step S1500 of executing a subspace identification analysis based on the plurality of current measurements I and on the plurality of dynamic voltages.

Subspace identification analysis are known manners for, knowing various measurements of a given system, at various time instants, determining a state of variables of the system which cannot be directly measured. In the case of the method 1000, in general, the subspace identification analysis can be used to determine the value of the impedance of the battery B based on the plurality of current measurements I and on the plurality of dynamic voltages. In particular, in preferred embodiments, the subspace identification analysis can be performed with the plurality of current measurements I as input and the plurality of dynamic voltages as output.

Various techniques are known for performing a subspace identification analysis. For explanatory purposes, in the following one possible implementation will be described. It will however be clear that the invention is not limited thereto.

In some preferred embodiments, the subspace identification analysis can be based on a state-space representation of the type of

$$x_{k+1} = A\, x_k + B\, u_k$$

$$y_{k+1} = C\, x_k + D\, u_k$$

wherein

- k represents a time instant of the time window W,

- k+1 represents a time instant subsequent to k, in some embodiments, the distance in time between k and k+1 can correspond to the distance in time between sampling points for the current measurements I and/or for the voltage measurements V

- $x_k$ represents a state vector at time k,

- $u_k$ represents a current measurement I, at time k,

- $y_k$ represents a value of the plurality of dynamic voltages, at time k,

- A represents a state transition matrix, also known as system matrix,

- B represents a control input matrix, which can comprise the plurality of current measurements (I),

- C represents an output matrix, which can comprise the plurality of dynamic voltages,

- D represents a feedthrough matrix

In the following, an example using this implementation with N indicating the total number of data points in the time window W will be discussed.

The state vector x can be expressed as a matrix have one column and a number of rows which depends on the number P of RC elements, or poles, of the battery B. That is, the impedance of the battery B can be described by a function having a number of poles P, or an equivalent RC circuit, having a number P of RC elements. In some embodiments, the number of poles P is at least 1, preferably 2, even more preferably 3. With a generic number of poles P, the state vector x can be described as:

$$x = \begin{bmatrix} V_{RC1} \\ \cdots \\ V_{RCP} \end{bmatrix}$$

Each rows in the state vector x can comprise the dynamic potential of the given RC element. For instance, in case of a battery B modelled by a function having has two poles, the state vector can be expressed as

$$x = \begin{bmatrix} V_{RC1} \\ V_{RC2} \end{bmatrix}$$

where $V_{RC1}$ corresponds to the dynamic potential of a first RC element and $V_{RC2}$ corresponds to the dynamic potential of a second RC element.

The state transition matrix A can be a diagonal matrix with a number of rows equal to the number of poles P. The diagonal elements represents the time constant of the respective RC element.

$$A = \begin{bmatrix} e^{-t/\tau 1} & \cdots & 0 \\ \cdots & \cdots & \cdots \\ 0 & \cdots & e^{-t/\tau P} \end{bmatrix}$$

where $\tau 1$ corresponds to the time constant of the first RC element and $\tau P$ corresponds to the time constant of the $P^{th}$ RC element and where t indicates time, preferably the amount of time between two consecutive sampled points in the time window W.

For instance, for a two pole system A can be expressed as:

$$A = \begin{bmatrix} e^{-t/\tau 1} & 0 \\ 0 & e^{-t/\tau 2} \end{bmatrix}$$

The control input matrix B can then be expressed as a matrix having one column and P rows:

$$B = \begin{bmatrix} R1 * (1 - e^{-\frac{t}{\tau 1}}) \\ ... \\ RP * (1 - e^{-\frac{t}{\tau P}}) \end{bmatrix}$$

where R1 - RP represent the resistance of the respective RC elements. For instance, for a two pole system B can be expressed as:

$$B = \begin{bmatrix} R1 * (1 - e^{-\frac{t}{\tau 1}}) \\ R2 * (1 - e^{-\frac{t}{\tau 2}}) \end{bmatrix}$$

The output matrix C can be expressed as a matrix having one row and P columns, where each element of the matrix is substantially equal to 1. For instance, for a two pole system C can be expressed as:

$$C = [1 \ 1]$$

and the feedthrough matrix D can be expressed as

$$D = R_0$$

where $R_0$ can be referred to as ohmic resistance. Thanks to this configuration it is possible to extract the value of the impedance of the battery B.

More specifically, for a generic data point k, the generic state space equation can be repeated for the next samples to get the output equation form as:

$$\begin{bmatrix} y[k] \\ y[k+1] \\ \vdots \\ y[k+i-1] \end{bmatrix} = \underbrace{\begin{bmatrix} C \\ C*A \\ \vdots \\ C*A^{i-1} \end{bmatrix}}_{O_i} * x[k] + \underbrace{\begin{bmatrix} D & & & \\ CB & D & & \\ \vdots & \ddots & \ddots & \\ CA^{i-2}B & ... & CB & D \end{bmatrix}}_{\Psi_i} * \begin{bmatrix} u[k] \\ u[k+1] \\ \vdots \\ u[k+i-1] \end{bmatrix}$$

where $O_i$ is referred to as the observability matrix.
Also, for a generic data point k, the generic state equation can be rewritten as:

$$x[k] = A^i * x[k-i] + \begin{bmatrix} A^{i-1} * B & \dots & A^2 B & AB & B \end{bmatrix} * \begin{bmatrix} u[k-i] \\ \vdots \\ u[k] \end{bmatrix}$$

$$\underbrace{\qquad\qquad\qquad\qquad\qquad}_{\mho_i}$$

where $\mho_i$ is referred to as the reverse controllability matrix.

The two equations above, involving the observability matrix $O_i$ and the reverse controllability matrix $\mho i$ form the base for the subspace identification method.

In general, subspace identification methods use the above equations and operate geometric transformations on the Henkel matrices to obtain the value of the battery impedance. More specifically, various subspace identification methods are known by the skilled person and can be implemented for obtaining the impedance value.

Preferably, subspace identification methods defined for a combination of stochastic and deterministic system can be used. One example implementation can be found for instance in chapter 6.1 of "Subspace Identification for Linear Systems Theory - Implementation - Applications" Peter Van Overschee / Bart De Moor, for instance in page 169 of the publication year 1996.

The method 1000 can then further comprises a step S1600 of computing the impedance from an output of the subspace identification analysis.

More specifically, the step S1600 can compute the eigenvector of the state transition matrix A and thus obtain the time constants (T1 - TP) of the RC elements of the battery B. The remaining unknown in the state equation found in the B matrix, namely R1 - RP, can then be computed by solving the state equation using linear algebra.

Moreover, in some preferred embodiments, the subspace identification analysis can comprise steps S5510 and S5520 of orthogonal projection of respectively block Hankel matrix of the current measurements I acquired at step S1100 and of the dynamic voltages obtained from step S1400, S4400. The orthogonal projection advantageously allows noise to be projected out from the states.

In particular, the input Hankel matrix of the current measurements I can be defined as:

$$U_{0|2i-1} = \begin{bmatrix} u[0] & u[1] & \cdots & u[M-1] \\ u[1] & u[2] & \dots & u[M] \\ \vdots & \vdots & \vdots & \vdots \\ u[i-1] & u[i] & \cdots & u[i+M-2] \\ u[i] & u[i+1] & \dots & u[i+M-1] \\ u[i+1] & u[i+2] & \dots & u[i+M] \\ \vdots & \vdots & \vdots & \vdots \\ u[2*i-1] & u[2*i] & \dots & u[2*i+M-2] \end{bmatrix}$$

$$= \begin{bmatrix} U_{0|i-1} \\ U_{i|2i-1} \end{bmatrix}$$

$$= \begin{bmatrix} U_p \\ U_f \end{bmatrix}$$

where;

- i is a value greater than P, preferably i = 2*P, or greater, where P is the number of poles of the battery B as previously described,
- N is the total number of data points in the window
- M = N+1-(2*i)

Similarly, the output Hankel matrix of the dynamic voltages V can be defined as:

$$Y_{0|2i-1} = \begin{bmatrix} y[0] & y[1] & \cdots & y[M-1] \\ y[1] & y[2] & \cdots & y[M] \\ \vdots & \vdots & \vdots & \vdots \\ y[i-1] & y[i] & \cdots & y[i+M-2] \\ y[i] & y[i+1] & \cdots & y[i+M-1] \\ y[i+1] & y[i+2] & \cdots & y[i+M] \\ \vdots & \vdots & \vdots & \vdots \\ y[2*i-1] & y[2*i] & \cdots & y[2*i+M-2] \end{bmatrix}$$

$$= \begin{bmatrix} Y_{0|i-1} \\ Y_{i|2i-1} \end{bmatrix}$$

$$= \begin{bmatrix} Y_p \\ Y_f \end{bmatrix}$$

Here it is noted that the formal distinction in past components, namely $U_p$ and $Y_p$, and future components namely $U_f$ and $Y_f$, is arbitrary since all the data in the matrices are already measured and available.

Moreover, in some preferred embodiments, the subspace identification analysis can comprise steps S5530 and S5540 of oblique projection of respectively the computed orthogonal projections of the block Hankel matrix of the current measurements I and of the dynamic voltages. The oblique projection advantageously allows to obtain filtered observability matrix.

Moreover, in some preferred embodiments, the subspace identification analysis can further comprise a step S5550 of singular vector decomposition to obtain the system matrix A. In particular, using as input for step S5550 the output of steps S5330 and S5340, it is possible using linear algebra to compute the value of the observability matrix $O_i$, which comprises the system matrix A. From the system matrix A it is possible to obtain the impedance value from the system matrix. Alternatively, or in addition, in some embodiments step S5550 might use as input the output of the steps S5510 and S5520 instead. Still alternatively, or in addition, step S5550 might use as input the output of step S1400, S4400.

That is, summarizing, the output of step S1500, S5500 can provide the eigenvector of the system matrix A. Computing the eigenvalues of the output of subspace can calculate the values of the exponential terms of the system matrix A, for instance, for a two pole system, $\tau 1$ and $\tau 2$. Those exponential terms can be calculated using the sampling time and natural logarithm. Once the exponential terms are known, the unknown resistors, namely R0, R1-RP, occur linearly in the system matrix equations. The values of R0, R1-RP can thus be computed by solving the dynamic voltage of the window with respect to the current measurement, using for instance a linear least squares method. This provides then values of R0, R1-RP, $\tau 1$-$\tau$P which are the parameters defining the dynamic impedances of the battery system.

For instance, for a two pole system, the values R0, R1, R2, and $\tau 1$, $\tau 2$, can be obtained, from which the impedance of the battery B can be computed.

The description above has been provided with respect to a method. The invention is however not limited to being implemented as a method. In particular, as visible in figure 2, the invention can also be implemented by an apparatus 2000 for estimating an impedance of a battery B. In particular, the apparatus can comprise a memory 2200 and a processor 2300, wherein the memory 2200 comprises instructions configured to, when executed, cause the processor 2300 to carry out any of the steps previously described.

Preferably, the apparatus 2000 can further comprise communication means 2100 for obtaining the plurality of voltage measurements V and the plurality of current measurements I. In the embodiment illustrated in figure 2, the plurality of voltage measurements V and the plurality of current measurements I can be obtained by, respectively, a voltage meter VM and a current meter IM. The communication means 2100 could communicate directly with one or more of the voltage meter VM and the current meter IM. Alternatively, or in addition, one or more of the voltage meter VM and the current meter IM could communicate with a further entity, for instance a controller of the battery B, which could then communicate the measurements to the communication means 2100.

This advantageously allows the apparatus 2000 t perform the method on a battery B remotely located simply by using the voltage meter VM and the current meter IM connected to the battery B and/or to the load L. It will be clear that the acquiring step S1100 can be similarly performed through communication means 2100 so that the method can be similarly executed on a battery B remotely located.

Similarly, the invention can be implemented as any of a software, a computer program, a computer-program product, a computer-readable storage medium including program code, which, when executed on a processor 2300, causes the processor 2300 to carry out any of the steps previously described.

It is to be understood that the features mentioned above may be used not only in the respective combinations indicated, but also in other combinations or in isolation without departing from the scope of the invention which is defined by the appended claims.

It has thus be described how the invention allows a precise estimation of the impedance of a battery based merely on voltage and current measurements, with a method which has a low computing effort and can thus be executed quickly and efficiently to correctly compute the impedance value at any given time, without the disadvantages of the state of the art.

### List of reference numerals

1000: method for estimating an impedance of a battery
S1100: voltage and current data acquisition
S1200: time window identification
S1300: open circuit voltage determination
S1400: dynamic voltage determination
S1500: subspace identification analysis execution
S1600: impedance computation

2000: apparatus for estimating an impedance of a battery
2100: communication means
2200: memory
2300: processor
B: battery
IM: current meter
VM: voltage meter
L: load

T1, T2: time
I: current measurement
V: voltage measurement
RVI: relaxed voltage interval
DLI: dynamic load interval

S4400: dynamic voltage determination
S4410: estimated initial state of charge determination
S4420: plurality of estimated states of charge determination
S4430: plurality of estimated open circuit voltages determination
S4440: plurality of dynamic voltages determination

S5500: subspace identification analysis execution
S5510: orthogonal projection of block Hankel matrix
S5520: orthogonal projection of block Hankel matrix
S5530: oblique projection of orthogonally projected block Hankel matrix
S5540: oblique projection of orthogonally projected block Hankel matrix
S5550: linear fitting and singular vector decomposition

### Claims

1. A method (1000) for estimating an impedance of a battery (B), the method comprising the steps of:

acquiring (S1100) data of the battery (B) during at least a predetermined time range, the data comprising at least a plurality of voltage measurements (V) and a plurality of current measurements (I),
determining (S1200) a time window (W) within the predetermined time range, the time window (W) starting after a relaxed voltage interval (RVI) and comprising a dynamic load interval (DLI),
determining (S1300) an initial voltage, the initial voltage being the voltage measurement (V) at the start of the time window (W),
determining (S1400, S4400) a plurality of dynamic voltages based on the voltage measurements (V) in the time window (W) and the initial voltage,
executing a subspace identification analysis (S1500, S5500) based on the plurality of current measurements (I) and on the plurality of dynamic voltages,
computing (1600) the impedance from an output of the subspace identification analysis (S1500),
wherein the step of determining (S4400) the dynamic voltage comprises the steps of:

determining (S4410) an estimated initial state of charge based on the initial voltage, the estimated initial state of charge being the estimated state of charge at the start of the time window (W),
determining (S4420) a plurality of estimated states of charge throughout the time window (W) based on the estimated initial state of charge,
determining (S4430) a plurality of estimated open circuit voltages throughout the time window (W) based on the estimated plurality of states of charge,
determining (S4440) the plurality of dynamic voltages as, at any given time throughout the time window (W), a difference between the voltage measurement (V) and the respective estimated open circuit voltage at the given time.

2. The method according to claim 1,
wherein the time window (W) starts immediately after an end of the relaxed voltage interval (RVI).

3. The method according to claim 1,
wherein the time window (W) starts within a predetermined time after an end of the relaxed voltage interval (RVI).

4. The method according to any previous claim,
wherein the dynamic load interval (DLI) is a time interval during which one or more of the following conditions apply:

- a value of an integral of an absolute value of the current measurements (I) is within a predetermined range, preferably higher than 1% of the capacity of the battery (B), and/or preferably lower than 5% of the capacity of the battery (B), and/or even more preferably lower than 2.5% of the capacity of the battery (B),
- a difference of a maximum value of an integral of the current measurements (I) during the time interval and a minimum value of the integral of the current measurements (I) during the time interval is within a predetermined range, preferably higher than 2.5% and/or preferably lower than 5% of the battery cell capacity,
- a value of statistical measure for dispersion of the current measurements (I), preferably the standard deviation of the current measurements (I), is higher than a predetermined value, preferably higher than 10% of the C-rate of the battery, even more preferably higher than 25% of the C-rate of the battery
- an absolute value of a differential of the current measurements (I) reaches a predetermined threshold, preferably higher than 1 C-rate/s,
- an absolute value of a differential of a moving average of the current measurements (I) reaches a predetermined threshold, preferably higher than 1 C-rate/s,
- a Fourier transformation of the current measurements (I) results in one or more frequency peaks other than at 0 Hz.

5. The method according to any previous claim,
wherein the dynamic load interval (DLI) has a duration of and/or at least 1 minute, preferably of and/or at least 5 minutes.

6. The method according to any previous claim,

wherein the battery (B) can be modelled as having one or more RC elements, and
wherein the dynamic load interval (DLI) has a duration of and/or at least 1 time, preferably of and/or at least 5 times, the biggest of the one or more RC elements.

7.  The method according to any previous claim,
    wherein the subspace identification analysis is performed with the plurality of current measurements (I) as input and the plurality of dynamic voltages as output.

8.  The method according to any previous claim,
    wherein the subspace identification analysis is based on a state-space representation of the type of

$$x_{k+1} = A\ x_k + B\ u_k$$

$$y_{k+1} = C\ x_k + D\ u_k$$

wherein

- k represents a time instant of the time window (W),
- k+1 represents a time instant subsequent to k,
- $x_k$ represents a state vector at time k,
- $u_k$ represents a current measurement (I) at time k,
- $y_k$ represents a value of the plurality of dynamic voltages at time k,
- A represents a state transition matrix,
- B represents a control input matrix,
- C represents an output matrix,
- D represents a feedthrough matrix.

9.  The method according to any previous claim, wherein the step (S5500) of executing a subspace identification analysis comprises any of the steps of:

    orthogonal projection (S5510) of block Hankel matrix of the current measurements (I),
    orthogonal projection (S5520) of block Hankel matrix of the dynamic voltages,
    oblique projection (S5530) of the orthogonal projection of the block Hankel matrix of the current measurements (I),
    oblique projection (S5530) of the orthogonal projection of the block Hankel matrix of the dynamic voltages.

10. The method according to any previous claim, wherein the step (S5500) of executing a subspace identification analysis further comprises the step of:
    singular vector decomposition (S5550) to obtain the system matrix A.

11. An apparatus (2000) for estimating an impedance of a battery (B), the apparatus comprising a memory (2200) and a processor (2300),
    wherein the memory (2200) comprises instructions configured to, when executed, cause the processor (2300) to carry out the steps of any previous claim.

12. The apparatus (2000) according to claim 11 further comprising communication means (2100) for obtaining the plurality of voltage measurements (V) and the plurality of current measurements (I).

13. A software which, when executed on a processor (2300), causes the processor (2300) to carry out the steps of any of claims 1-10.

**Patentansprüche**

1.  Verfahren (1000) zur Schätzung einer Impedanz einer Batterie (B), wobei das Verfahren die Schritte umfasst:

    Erfassen (S1100) von Daten der Batterie (B) während mindestens eines vorbestimmten Zeitbereichs, wobei die Daten mindestens eine Mehrzahl von Spannungsmessungen (V) und eine Mehrzahl von Strommessungen (I) umfassen,
    Bestimmen (S1200) eines Zeitfensters (W) innerhalb des vorbestimmten Zeitbereichs, wobei das Zeitfenster (W) nach einem Relaxationsspannungsintervall (RVI) beginnt und ein dynamisches Lastintervall (DLI) umfasst,

Bestimmen (S1300) einer Anfangsspannung, wobei die Anfangsspannung die Spannungsmessung (V) zu Beginn des Zeitfensters (W) ist,

Bestimmen (S1400, S4400) einer Mehrzahl von dynamischen Spannungen basierend auf den Spannungsmessungen (V) in dem Zeitfenster (W) und der Anfangsspannung,

Ausführen einer "Subspace Identification"-Analyse (S1500, S5500) basierend auf der Mehrzahl von Strommessungen (I) und auf der Mehrzahl von dynamischen Spannungen,

Berechnen (1600) der Impedanz aus einer Ausgabe der "Subspace Identification"-Analyse (S1500),

wobei der Schritt des Bestimmens (S4400) der dynamischen Spannung die Schritte umfasst:

Bestimmen (S4410) eines geschätzten anfänglichen Ladestatus basierend auf der Anfangsspannung, wobei der geschätzte anfängliche Ladestatus der geschätzte Ladestatus zu Beginn des Zeitfensters (W) ist,

Bestimmen (S4420) einer Mehrzahl von geschätzten Ladestatus im Verlauf des Zeitfensters (W) basierend auf dem geschätzten anfänglichen Ladestatus,

Bestimmen (S4430) einer Mehrzahl von geschätzten Leerlaufspannungen im Verlauf des Zeitfensters (W) basierend auf der geschätzten Mehrzahl von Ladestatus,

Bestimmen (S4440) der Mehrzahl von dynamischen Spannungen als eine Differenz, zu einem gegebenen Zeitpunkt im Verlauf des Zeitfensters (W), zwischen der Spannungsmessung (V) und der entsprechenden geschätzten Leerlaufspannung zu dem gegebenen Zeitpunkt.

2. Verfahren nach Anspruch 1,
wobei das Zeitfenster (W) unmittelbar nach einem Ende des Relaxationsspannungsintervalls (RVI) beginnt.

3. Verfahren nach Anspruch 1,
wobei das Zeitfenster (W) innerhalb einer vorbestimmten Zeit nach einem Ende des Relaxationsspannungsintervalls (RVI) beginnt.

4. Verfahren nach einem der vorstehenden Ansprüche, wobei das dynamische Lastintervall (DLI) ein Zeitintervall ist, während dessen eine oder mehrere der folgenden Bedingungen gelten:

- ein Wert eines Integrals eines absoluten Werts der Strommessungen (I) ist innerhalb eines vorbestimmten Bereichs, vorzugsweise höher als 1 % der Kapazität der Batterie (B) und/oder vorzugsweise niedriger als 5 % der Kapazität der Batterie (B) und noch stärker bevorzugt geringer als 2,5 % der Kapazität der Batterie (B),
- eine Differenz zwischen einem maximalen Wert eines Integrals der Strommessungen (I) während des Zeitintervalls und einen minimalen Wert des Integrals der Strommessungen (I) während des Zeitintervalls liegt innerhalb eines vorbestimmten Bereichs, vorzugsweise höher als 2,5 % und/oder vorzugsweise geringer als 5 % der Batteriezellkapazität,
- ein Wert statistischer Messung zur Streuung der Strommessungen (I), vorzugsweise die Standardabweichung der Strommessungen (I), ist höher als ein vorbestimmter Wert, vorzugsweise höher als 10 % der C-Rate der Batterie, noch stärker bevorzugt höher als 25 % der C-Rate der Batterie,
- ein absoluter Wert eines Differenzials der Strommessungen (I) erreicht einen vorbestimmten Schwellenwert, vorzugsweise höher als 1 C-Rate/s,
- ein absoluter Wert eines Differenzials eines gleitenden Durchschnitts der Strommessungen (I) erreicht einen vorbestimmten Schwellenwert, vorzugsweise höher als 1 C-Rate/s,
- eine Fourier-Transformation der Strommessungen (I) führt anders als bei 0 Hz zu einem oder mehreren Frequenz-Peaks.

5. Verfahren nach einem der vorstehenden Ansprüche, wobei das dynamische Lastintervall (DLI) eine Dauer von 1 Minute und/oder mindestens 1 Minute, vorzugsweise von 5 Minuten und/oder mindestens 5 Minuten aufweist.

6. Verfahren nach einem der vorstehenden Ansprüche, wobei die Batterie (B) so modelliert werden kann, dass sie ein oder mehrere RC-Glieder aufweist, und
wobei das dynamische Lastintervall (DLI) eine Dauer von 1-mal und/oder mindestens 1-mal, vorzugsweise von 5-mal und/oder mindestens 5-mal, dem größten der ein oder mehreren RC-Glieder, aufweist.

7. Verfahren nach einem der vorstehenden Ansprüche, wobei die "Subspace Identification"-Analyse mit der Mehrzahl von Strommessungen (I) als Eingabe und der Mehrzahl von dynamischen Spannungen als Ausgabe durchgeführt wird.

8. Verfahren nach einem der vorstehenden Ansprüche,
wobei die "Subspace Identification"-Analyse auf einer Zustandsraumdarstellung des Typs

$$x_{k+1} = A x_k + B u_k$$

$$y_{k+1} = C x_k + D u_k$$

basiert, wobei

- k einen Zeitmoment des Zeitfensters (W) wiedergibt,
- k+1 einen auf k folgenden Zeitmoment wiedergibt,
- $x_k$ einen Statusvektor zum Zeitpunkt k wiedergibt,
- $u_k$ eine Strommessung (I) zum Zeitpunkt k wiedergibt,
- $y_k$ einen Wert der Mehrzahl von dynamischen Spannungen zum Zeitpunkt k wiedergibt,
- A eine Statusübergangsmatrix wiedergibt,
- B eine Steuerungseingabematrix wiedergibt,
- C eine Ausgabematrix wiedergibt,
- D eine Durchführungsmatrix wiedergibt.

9. Verfahren nach einem der vorstehenden Ansprüche, wobei der Schritt (S5500) der Ausführung einer "Subspace Identification"-Analyse beliebige der Schritte umfasst:

orthogonale Projektion (S5510) der Block-Hankel-Matrix der Strommessungen (I),
orthogonale Projektion (S5520) der Block-Hankel-Matrix der dynamischen Spannungen,
Schrägprojektion (S5530) der orthogonalen Projektion der Block-Hankel-Matrix der Strommessungen (I),
Schrägprojektion (S5530) der orthogonalen Projektion der Block-Hankel-Matrix der dynamischen Spannungen.

10. Verfahren nach einem der vorstehenden Ansprüche, wobei der Schritt (S5500) der Ausführung einer "Subspace Identification"-Analyse ferner den Schritt umfasst: singuläre Vektorzerlegung (S5550) zum Erhalten der Systemmatrix A.

11. Vorrichtung (2000) zur Schätzung einer Impedanz einer Batterie (B), wobei die Vorrichtung einen Speicher (2200) und einen Prozessor (2300) umfasst,
wobei der Speicher (2200) Anweisungen umfasst, die dazu ausgelegt sind, bei Ausführung den Prozessor (2300) zum Durchführen der Schritte nach einem der vorstehenden Ansprüche zu veranlassen.

12. Vorrichtung (2000) nach Anspruch 11, ferner umfassend Kommunikationsmittel (2100) zum Erhalten der Mehrzahl von Spannungsmessungen (V) und der Mehrzahl von Strommessungen (I).

13. Software, die bei Ausführung auf einem Prozessor (2300) den Prozessor (2300) zum Durchführen der Schritte nach einem der Ansprüche 1 bis 10 veranlasst.

**Revendications**

1. Procédé (1000) d'estimation d'une impédance d'une batterie (B), le procédé comprenant les étapes consistant à :

acquérir (S1100) des données de la batterie (B) pendant au moins une plage de temps prédéterminée, les données comprenant au moins une pluralité de mesures de tension (V) et une pluralité de mesures de courant (I),
déterminer (S1200) une fenêtre de temps (W) dans la plage de temps prédéterminée, la fenêtre de temps (W) commençant après un intervalle de tension relaxée (RVI) et comprenant un intervalle de charge dynamique (DLI),
déterminer (S1300) une tension initiale, la tension initiale étant la mesure de tension (V) au début de la fenêtre de temps (W),
déterminer (S1400, S4400) une pluralité de tensions dynamiques sur la base des mesures de tension (V) dans la fenêtre de temps (W) et de la tension initiale,
exécuter une analyse d'identification de sous-espace (S1500, S5500) sur la base de la pluralité de mesures de courant (I) et de la pluralité de tensions dynamiques,
calculer (1600) l'impédance à partir d'une sortie de l'analyse d'identification de sous-espace (S1500),
l'étape de détermination (S4400) de la tension dynamique comprenant les étapes consistant à :

déterminer (S4410) un état initial estimé de charge sur la base de la tension initiale, l'état initial estimé de charge étant l'état estimé de charge au début de la fenêtre de temps (W),
déterminer (S4420) une pluralité d'états estimés de charge dans toute la fenêtre de temps (W) sur la base de l'état initial estimé de charge,
déterminer (S4430) une pluralité de tensions estimées en circuit ouvert dans toute la fenêtre de temps (W) sur la base de la pluralité estimée d'états de charge,
déterminer (S4440) la pluralité de tensions dynamiques comme étant, à n'importe quel moment donné dans toute la fenêtre de temps (W), une différence entre la mesure de tension (V) et la tension estimée respective en circuit ouvert au moment donné.

2. Procédé selon la revendication 1,
dans lequel la fenêtre de temps (W) commence immédiatement après une fin de l'intervalle de tension relaxée (RVI).

3. Procédé selon la revendication 1,
dans lequel la fenêtre de temps (W) commence dans un délai prédéterminé après une fin de l'intervalle de tension relaxée (RVI).

4. Procédé selon l'une quelconque des revendications précédentes,
dans lequel l'intervalle de charge dynamique (DLI) est un intervalle de temps pendant lequel une ou plusieurs des conditions suivantes s'appliquent :

- une valeur d'une intégrale d'une valeur absolue des mesures de courant (I) se situe dans une plage prédéterminée, de préférence supérieure à 1 % de la capacité de la batterie (B), et/ou de préférence inférieure à 5 % de la capacité de la batterie (B), et/ou encore plus préférablement inférieure à 2,5 % de la capacité de la batterie (B),
- une différence entre une valeur maximale d'une intégrale des mesures de courant (I) pendant l'intervalle de temps et une valeur minimale de l'intégrale des mesures de courant (I) pendant l'intervalle de temps se situe dans une plage prédéterminée, de préférence supérieure à 2,5 % et/ou de préférence inférieure à 5 % de la capacité de cellule de batterie,
- une valeur de mesure statistique de dispersion des mesures de courant (I), de préférence l'écart-type des mesures de courant (I), est supérieure à une valeur prédéterminée, de préférence supérieure à 10 % du taux C de la batterie, encore plus préférablement supérieure à 25 % du taux C de la batterie,
- une valeur absolue d'un différentiel des mesures de courant (I) atteint un seuil prédéterminé, de préférence supérieur à 1 taux C/s,
- une valeur absolue d'un différentiel d'une moyenne mobile des mesures de courant (I) atteint un seuil prédéterminé, de préférence supérieur à 1 taux C/s,
- une transformation de Fourier des mesures de courant (I) donne lieu à un ou plusieurs pics de fréquence différents de 0 Hz.

5. Procédé selon l'une quelconque des revendications précédentes,
dans lequel l'intervalle de charge dynamique (DLI) a une durée de et/ou d'au moins 1 minute, de préférence de et/ou d'au moins 5 minutes.

6. Procédé selon l'une quelconque des revendications précédentes,

dans lequel la batterie (B) peut être modélisée comme ayant un ou plusieurs éléments RC, et
dans lequel l'intervalle de charge dynamique (DLI) a une durée de et/ou d'au moins 1 fois, de préférence de et/ou d'au moins 5 fois le plus grand du ou des éléments RC.

7. Procédé selon l'une quelconque des revendications précédentes,
dans lequel l'analyse d'identification de sous-espace est réalisée avec la pluralité de mesures de courant (I) en tant qu'entrée et avec la pluralité de tensions dynamiques en tant que sortie.

8. Procédé selon l'une quelconque des revendications précédentes,

dans lequel l'analyse d'identification de sous-espace est basée sur une représentation état-espace du type suivant :

$$X_{k+1} = A \ X_k + B \ U_k$$

$$Y_{k+1} = C \ X_k + D \ U_k$$

où :

k représente un moment de la fenêtre de temps (W),
k+1 représente un moment postérieur à k,
$X_k$ représente un vecteur d'état au moment k,
$U_k$ représente une mesure de courant (I) au moment k,
$Y_k$ représente une valeur de la pluralité de tensions dynamiques au moment k,
A représente une matrice de transition d'état,
B représente une matrice d'entrée de commande,
C représente une matrice de sortie,
D représente une matrice de traversée.

9. Procédé selon l'une quelconque des revendications précédentes, dans lequel l'étape (S5500) d'exécution d'une analyse d'identification de sous-espace comprend l'une quelconque des étapes suivantes :

une projection orthogonale (S5510) d'une matrice de Hankel par blocs des mesures de courant (I),
une projection orthogonale (S5520) d'une matrice de Hankel par blocs des tensions dynamiques,
une projection oblique (S5530) de la projection orthogonale de la matrice de Hankel par blocs des mesures de courant (I),
une projection oblique (S5530) de la projection orthogonale de la matrice de Hankel par blocs des tensions dynamiques.

10. Procédé selon l'une quelconque des revendications précédentes, dans lequel l'étape (S5500) d'exécution d'une analyse d'identification de sous-espace comprend en outre l'étape suivante :
une décomposition en vecteurs singuliers (S5550) afin d'obtenir la matrice de système A.

11. Appareil (2000) d'estimation d'une impédance d'une batterie (B), l'appareil comprenant une mémoire (2200) et un processeur (2300),
la mémoire (2200) comprenant des instructions configurées, lorsqu'elles sont exécutées, pour amener le processeur (2300) à réaliser les étapes selon l'une quelconque des revendications précédentes.

12. Appareil (2000) selon la revendication 11, comprenant en outre un moyen de communication (2100) permettant d'obtenir la pluralité de mesures de tension (V) et la pluralité de mesures de courant (I).

13. logiciel qui, lorsqu'il est exécuté sur un processeur (2300), amène le processeur (2300) à réaliser les étapes selon l'une quelconque des revendications 1 à 10.

*Fig. 1*  1000

*Fig. 2*  2000

Fig. 3A

Current [A]

Time [s]

T1
T2
RVI
DLI
W
I

×10⁴

Fig. 3B

*Fig. 4*

S4400

```
┌──────────────┐
│    S4410     │
└──────┬───────┘
       │
       ▼
┌──────────────┐
│    S4420     │
└──────┬───────┘
       │
       ▼
┌──────────────┐
│    S4430     │
└──────┬───────┘
       │
       ▼
┌──────────────┐
│    S4440     │
└──────────────┘
```

*Fig. 5*

S5500

```
┌──────────────┐
│    S5510     │
└──────┬───────┘
       │
       ▼
┌──────────────┐
│    S5520     │
└──────┬───────┘
       │
       ▼
┌──────────────┐
│    S5530     │
└──────┬───────┘
       │
       ▼
┌──────────────┐
│    S5540     │
└──────┬───────┘
       │
       ▼
┌──────────────┐
│    S5550     │
└──────────────┘
```

*Fig. 6A*

*Fig. 6B*

*Fig. 7A*

*Fig. 7B*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Identification of a bilinear and parameter-varying model for lithium-ion batteries by subspace methods. **REMMLINGER JURGEN et al.** 2015 AMERICAN CONTROL CONFERENCE (ACC). IEEE, 17 June 2013
- Linear parameter varying battery model identification using subspace methods. **HU Y et al.** JOURNAL OF POWER SOURCES. ELSEVIER, 01 March 2011, vol. 196
- On-line adaptive battery impedance parameter and state estimation considering physical principles in reduced order equivalent circuit battery models part 2. Parameter and state estimation. **FLEISCHER CHRISTIAN et al.** JOURNAL OF POWER SOURCES. ELSEVIER, 27 March 2014, vol. 262

- Sequential Monte Carlo Filter for State-of-Charge Estimation of Lithium-Ion Batteries Based on Auto Regressive Exogenous Model. **DONG GUANGZHONG et al.** IEEE TRANSACTIONS ON INDUSTRIAL ELECTRONICS. IEEE SERVICE CENTER, 01 November 2019, vol. 66
- New Battery Model and State-of-Health Determination Through Subspace Parameter Estimation and State-Observer Techniques. **GOULD C R et al.** IEEE TRANSACTIONS ON VEHICULAR TECHNOLOGY. IEEE, 01 October 2009, vol. 58
- **PETER VAN OVERSCHEE ; BART DE MOOR.** Subspace Identification for Linear Systems Theory - Implementation - Applications. 1996, 169